# EUROPEAN PATENT SPECIFICATION

(11) **EP 0 573 269 B1**
(45) Date of publication and mention of the grant of the patent: **05.01.2000**
(21) Application number: 93304261.6
(22) Date of filing: 02.06.1993
(51) Int. Cl.: H01L 21/205, H01L 21/20

(54) **Method of preparing compound semiconductor**
Herstellungsverfahren von Verbindungshalbleitern
Procédé de fabrication de semi-conducteur composé

(30) Priority: 02.06.1992 JP 14180692
(43) Date of publication of application: 08.12.1993
(73) Proprietor: Mitsubishi Chemical Corporation, Chiyoda-ku Tokyo (JP)
(72) Inventor: Goto, Hideki, Ibaraki (JP); Fujii, Katsushi, Ibaraki (JP); Shimoyama, Kenji, Ibaraki (JP)
(74) Representative: Paget, Hugh Charles Edward

(56) References cited:
- GB-A- 2 192 198
- PATENT ABSTRACTS OF JAPAN vol. 016, no. 259 (E-1215)11 June 1992 & JP-A-04 057 319 (TOSHIBA K.K.) 25 February 1992
- PATENT ABSTRACTS OF JAPAN vol. 012, no. 913 (E-617)4 June 1988 & JP-A-62 296 415 (NEC CORP.) 23 December 1987
- PATENT ABSTRACTS OF JAPAN vol. 11, no. 75 (C-408)6 March 1987 & JP-A-61 232 297 (NEC CORP.) 16 October 1986

## Description

The present invention relates to a method of forming a compound semiconductor layer, by a vapor phase growth of a compound semiconductor film using hydride and organometallic compound as raw material. In particular, the present invention relates to a method of preparing a compound semiconductor, which can achieve planarization (i.e. uniformity) of the growth layer and the control of the deposit on a protective film used in a selective growth.

GB-A-2 192 198 describes a method of vapor phase growth of a III-V group semiconductor film, as set out in the first part of claim 1.

For the purpose of improving the performance of a compound semiconductor device, a device using a two-dimensional gas or a quantum effect device has been much developed. It has been needed to control growth rate precisely in the preparation of these devices, and a molecular-beam epitaxial growth (hereinafter referred to as MBE) method or a metal-organic vapor phase epitaxial growth (hereinafter referred to as MOVPE) method has been usually used. Actually, a steep hetero-junction interface has been formed in an atom-layer level by using these growth methods.

In case of the application of these structures to a device, planarization of the hetero-junction interface will have a great influence on the characteristics of a device. For example, in a compound interface containing aluminum, the migration distance of the compound molecules containing aluminum is short, then the planarization will not be well effected. This poses the problem that electron mobility in the interface will be deteriorated. Recently, a selective growth method has been employed so as to more optimize a device structure. The merits of the selective growth method are that a high-quality selective growth region can be obtained and also a high-performance device can be obtained, as a defect-free and comparatively low-temperature process can be realized. In general, selective growth has been carried out by the MOVPE method, because it has been found very difficult by the MBE method.

However, in a process of selective growth, there will arise restrictions on the growth conditions, the mixed-crystal ratio, the mask width and so on, in order not to deposit any polycrystals on a protective film. Especially in case of a compound containing aluminum, the more the mixed-crystal ratio of aluminum is raised and the higher mask width is, the more polycrystals will be deposited on a protective film, thereby bringing about the problem that a desired device structure cannot be obtained.

The present invention seeks to solve the above-mentioned problem. Accordingly, it is an object of the present invention to provide a method of preparing a compound semiconductor with an improved planarization of the growth surface and an excellent performance of the device.

In accordance with the present invention, there is provided a method as set out in claim 1.

The present invention will be explained in detail below. As raw materials of the compound semiconductor employed in the present invention, conventional hydrides and organometallic compounds containing no halogen elements may be used. As such hydrides, arsine (AsH₃), phosphine (PH₃), and the like are preferably used, and as organometallic compounds, trimethyl gallium (TMG), triethyl gallium (TEG), trimethyl aluminum (TMA), trimethyl indium (TMI), and the like are preferably used.

The present invention is characterized in that the thin-film is grown by alternately introducing (A) Group III metal organometallic compound gas and (B) halide and/or halogen gas into the crystal growth chamber. Thus making it possible to planarize the crystal growth surface and to stop the growth of polycrystals on a protective film.

As stated above, raw material containing no halogen elements should be used for crystal growth in the present invention. This is because the usage of such halides as gallium chloride (GaCl), diethyl gallium chloride (C₂H₅)₂ GaCl), arsenic trichloride (AsCl₃), as III-or V-group raw material will cause the crystal growth mechanism to be complicated, and cause the precise control of the growth rate to be difficult. Also, this is because a quartz tube will be eroded in case where a compound containing aluminum is to be grown.

In addition, it is preferable that mother elements included in the compound to be grown should not be contained in the halide and/or the halogen gas used in the present invention. As the halogens, Cl₂, I₂, F₂, and Br₂ are suitable in practice. As halide gas, hydrogen halide gas and sulfur halide gas are preferably used, and HBr, HI, HF, HCl, CCl₂F₂, SF₆, CH₃Cl, CCl₄, and mixtures thereof are for example practical. Above all, HCl is most preferable.

The amount of the halide gas and/or the halogen gas may be less than that in the case where the usual etching of the semiconductor thin-film surface is conducted, and may not be especially restricted. This may be selected by one skilled in the art, taking the size and the temperature of the growth chamber, and the like into consideration. The total pressure of gas to be passed is preferably selected at normal pressure or less. The growth temperature is selected in the range 600-800 °C.

In the present invention, the Group III organometallic compound raw material gas or the halide and/or halogen gas are alternately introduced into a growth chamber. The duration for a single supply step of the Group III metal organometallic compound raw material gas is preferably one minute or less, and is more preferably 30 seconds or less. If this duration exceeds more than one minute, the result of the present invention as the planarization of a crystal growth surface may not be attained. After the supply of Group III metals organometallic compound raw material gas is stopped, the halide gas and/or the halogen gas is supplied, and the duration in this case is also preferably one minute or less, and most preferably is 30 seconds or less.

The non-flow time of the above two kinds of gases, when they are exchanged, is not especially limited, but a longer time will cause reduction in productivity. Therefore, it is preferable that this time is 10 seconds or less, and it is more preferable that this time is 1-10 seconds in order that organometallic compound raw material gas and the halide and/or halogen gas will not be mixed on the growth surface.

The present invention is applicable to a conventional thin-film growth of a III-V group compound semiconductor, and particularly is applicable to a thin-film growth of a III-V group compound semiconductor containing aluminum. As a raw material gas containing aluminum, all kinds of well known materials can be used. But trialkyl aluminum is preferable, for the reason that it gives comparatively simple reaction, the behaviour of the gas generated after its decomposition is distinct, and it is fairly cheap. Also in this case, as the halide gas and/or halogen gas, HCl is preferably used.

As the dopant in the case where the film of the III-V group compound semiconductor obtained according to the present invention is doped, various well known ones can be employed. Among them, a dopant which enters the III-group site is especially effective, and this will be prominently realized when silicon or zinc is doped, especially when silicon or zinc is doped in a film of a III-V group compound semiconductor containing aluminum.

By the method of the present invention, the following results can be achieved. 1) The growth can be effected under almost equal growth conditions to those of a conventional MOVPE method, and it is possible to planarize the hetero junction interface, and to improve the planarization of a surface homology and a facet surface. 2) High quality crystal growth on a mask can be obtained without the deposit of polycrystal in a wide range. 3) The growth rate obtained can keep the same reproducibility and control as in a conventional MOVPE, though the rate may be reduced a few % by the addition of a trace amount of HCl, and it can be said that this is an effective method in a practical use.

Embodiments of the present invention will be described below by way of example in conjunction with the accompanying drawings, in which:

FIG. 1 is an explanatory diagram of the stripe pattern of SiNx film used in the Example and Comparative Examples 1 and 2.

FIG. 2 shows a gas-flow program used in the Examples.

FIG. 3 shows a gas-flow program used in Comparative Example 1.

### Example:

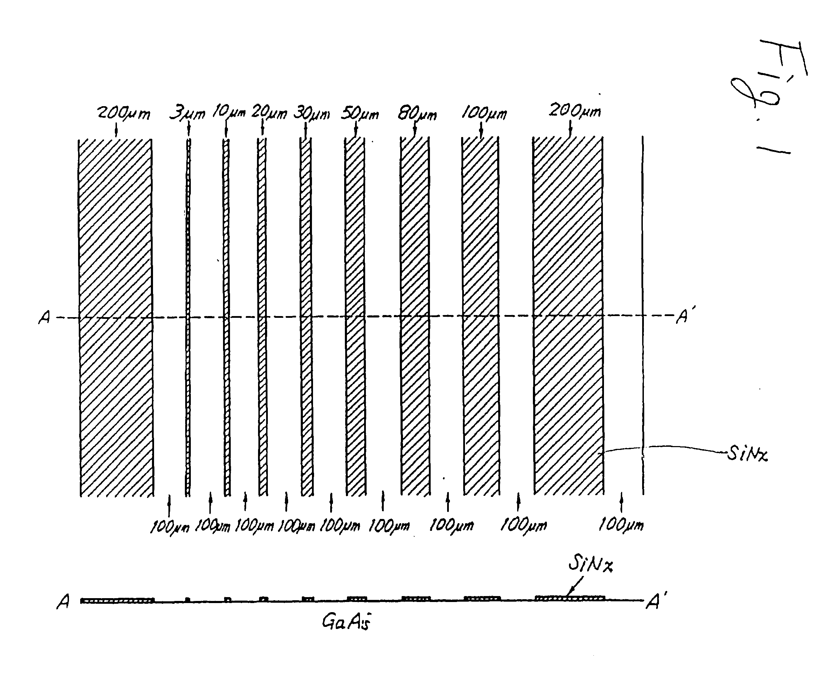

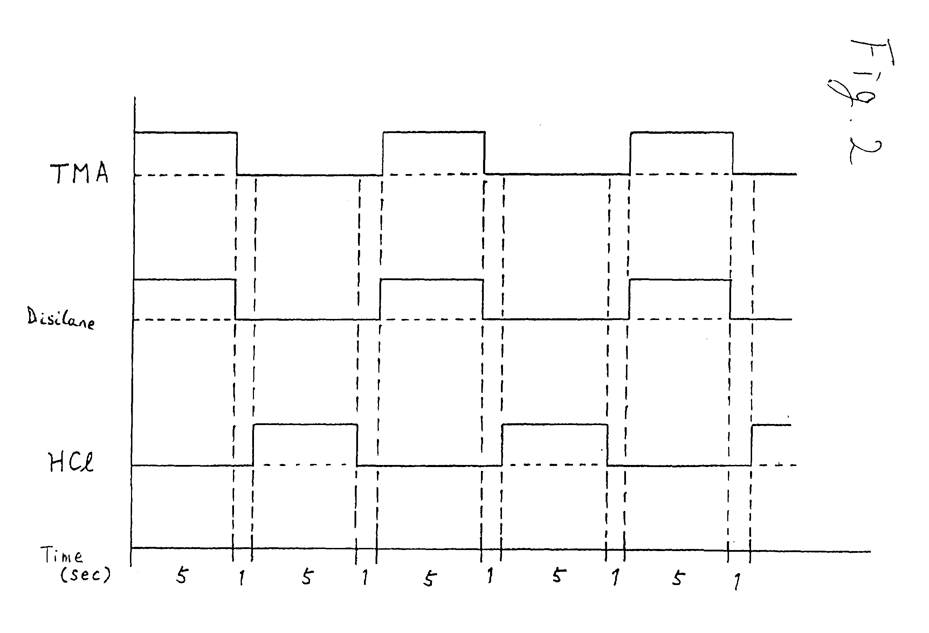

SiNx film was deposited on a GaAs substrate to 100 nm thick by a CVD plasma method. Then, the GaAs was partially exposed by using a photo-lithography. The distance between one exposed GaAs region and the next exposed GaAs region was varied from 2 µm to 1mm, in stripe patterns which are shown in FIG. 1. On this substrate was grown AlAs doped with Si, using a gas-flow program as shown in FIG. 2. TMA (trimethyl aluminum) as the Group III metal organometallic compound raw material gas, arsine (AsH₃) as the Group V raw material gas, and HCl as the halide gas were used respectively. At this time, the growth temperature was 700°C, the growth pressure was 10⁴ Pa (0.1 atm.) and the ratio of HCl and TMA was equal in mole concentration. Also, the growth speed of AlAs, in the case where the SiNx film was not present, was 1 µm/hr.

First, TMA was passed in an atmosphere of arsine and H₂ as a carrier gas for five seconds. Then, HCl passed for five seconds after an interval of one second, and then another one second interval followed. This complete cycle was repeated. In this way, the gas-flow program shown in FIG. 2 was carried out, and 180 cycles were repeated. During all these periods, arsine and H₂, the carrier gas, were always passed, and disilane (Si₂H₆), a doping source of Si, was supplied synchronously along with TMA, in an amount of 1x10¹⁶/cm³ which was equivalent to the doping ratio.

As a result, a few cores of AlAs were noticed to be formed on the SiNx film region more than 500 µm wide, but no core was noticed at all on the SiNx film of less than 500 µm wide. AlAs was selectively grown only on the exposed GaAs, and further the carrier concentration of the grown AlAs was measured to be 9x10¹⁷/cm³.

### Comparative Example 1:

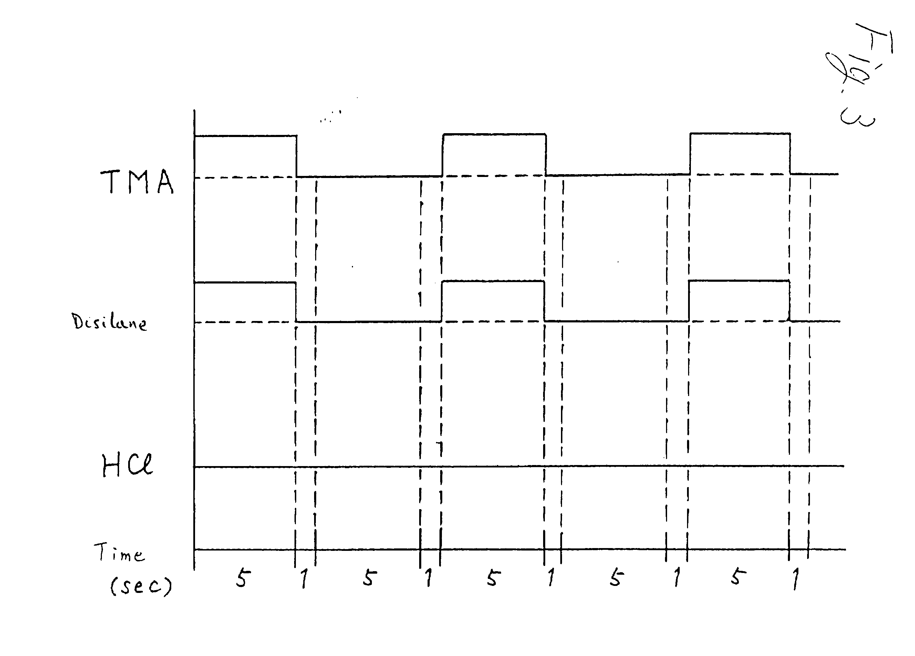

AlAs was grown according to the method of the above Example, except that the gas-flow program as shown in FIG. 3, in which HCl was not supplied, was used. The result was that the growth of AlAs polycrystal was noticed on almost all the surface of all the SiNx films.

### Comparative Example 2:

AlAs was grown according to the method of the above Example, except that TMA, disilane, arsine, and HCl were continuously supplied in an atmosphere of H₂, i.e. without the alternating supply thereof. As a result, as to the selective growth, in the same way as mentioned in the Example, very few cores of AlAs were found to be formed on the SiNx film of more than 500 µm wide, and the cores were not found at all on the SiNx of less than 500 µm wide. AlAs was selectively grown only on the exposed GaAs. The carrier concentration of the grown AlAs, however, was measured to be 1x10¹⁶/cm³ or less.

## Claims

1. A method of vapour phase growth of a III-V group compound semiconductor film, in which a Group V hydride and a Group III metal organometallic compound both containing no halogen elements as raw materials for the growth are introduced into a growth chamber and the III-V group compound semiconductor film is grown on the substrate in the growth chamber, wherein there is repeatedly carried out a growth procedure comprising the two steps of
(i) in a period (A) introducing into the growth chamber the Group III metal organometallic compound raw material gas, and
(ii) in a period (B), which follows a said period (A), introducing into the growth chamber at least one halide and/or halogen gas,
characterised in that the growth method is a selective growth method and the growth temperature is in the range 600 - 800°C.

2. A method according to claim 1, wherein each said period of introduction of Group III metal organometallic compound gas is one minute or less.

3. A method according to claim 1 or 2, wherein at least one halide gas is employed which is selected from HCl, HBr, HI, HF, CCl₂F₂, SF₆, CH₃Cl, and CCl₄.

4. A method according to claim 3, wherein the halide gas is HCl.

5. A method according to any one of claims 1 to 4, wherein the III-V group compound semiconductor contains aluminum.

## Revendications

1. Méthode de croissance en phase vapeur d'un film semi-conducteur d'un composé du groupe III-V ou un hydrure du groupe V et un composé organométallique d'un métal du groupe III ne contenant tous deux aucun élément d'halogène comme matières premières pour la croissance sont introduits dans une chambre de croissance et le film semi-conducteur en un composé du groupe III-V est tiré sur le substrat dans la chambre de croissance où est effectué de façon répétée un processus de croissance comprenant les deux étapes de :
(i) dans une période (A), introduire dans la chambre de croissance le gaz de matière première du composé organométallique du métal du groupe III, et
(ii) dans une période (B) qui suit ladite période (A), introduire dans la chambre de croissance au moins un halogénure et/ou halogène gazeux,
caractérisée en ce que la méthode de croissance est une méthode de croissance sélective et la température de croissance est dans la gamme de 600-800°C.

2. Méthode selon la revendication 1, où chaque période d'introduction du gaz du composé organométallique d'un métal du groupe III est de une minute ou moins.

3. Méthode selon la revendication 1 ou 2, où au moins un halogénure gazeux est employé qui est sélectionné parmi HCl, HBr, HI, HF, CCl₂F₂, SF₆, CH₃Cl et CCl₄.

4. Méthode selon la revendication 3, où l'halogénure gazeux est HCl.

5. Méthode selon l'une quelconque des revendications 1 à 4 où le semi-conducteur composé du groupe III-V contient de l'aluminium.

## Patentansprüche

1. Verfahren für das Dampfphasen-Wachstum eines Halbleiterfilms einer Verbindung der Gruppen III-V, worin ein Hydrid eines Elements der Gruppe V und eine Organometallverbindung eines Metalls der Gruppe III, die beide keine Halogenelemente als Rohmaterialien für das Wachstum enthalten, in eine Wachstumskammer eingebracht werden und der Verbindungs-Halbleiterfilm der Gruppen III-V auf dem Substrat in der Wachstumskammer wächst, worin wiederholt ein Wachstumsverfahren durchgeführt wird, das die folgenden beiden Schritte umfaßt:
(i) das Einbringen des Rohmaterialgases aus Organometallverbindung des Metalls der Gruppe III in einer Zeitspanne (A) und
(ii) das Einbringen zumindest eines Halogenid- und/oder Halogengases in die Wachstumskammer in einer Zeitspanne (B), die auf die Zeitspanne (A) folgt,
dadurch gekennzeichnet, daß das Wachstumverfahren ein selektives Wachstumsverfahren ist und die Wachstumstemperatur im Bereich von 600 bis 800 °C liegt.

2. Verfahren nach Anspruch 1, worin jede Zeitspanne des Einbringens von Organometallverbindungsgas eines Metalls der Gruppe III 1 min oder weniger beträgt.

3. Verfahren nach Anspruch 1 oder 2, worin zumindest ein Halogenidgas eingesetzt wird, das aus HCI, HBr, Hl, HF, CCl₂F₂, SF₆, CH₃Cl und CCl₄ ausgewählt ist.

4. Verfahren nach Anspruch 3, worin das Halogenidgas HCI ist.

5. Verfahren nach einem der Ansprüche 1 bis 4, worin der Verbindungs-Halbleiter der Gruppen III-V Aluminium enthält.
